# EUROPEAN PATENT APPLICATION

(11) **EP 4 589 505 A1**
(43) Date of publication of application: **23.07.2025**
(21) Application number: 23865438.8
(22) Date of filing: 11.09.2023
(51) Int. Cl.: G06Q 10/087, G06Q 30/016

(54) **CABLE MANAGEMENT SYSTEM AND CABLE MANAGEMENT METHOD**

(30) Priority: 12.09.2022 JP 2022144804
(71) Applicant: SUMITOMO ELECTRIC INDUSTRIES, LTD., Osaka-shi, Osaka 541-0041 (JP)
(72) Inventor: SAITO, Koichi, Osaka-shi, Osaka 541-0041 (JP)
(74) Representative: Müller-Boré & Partner Patentanwälte PartG mbB
(86) International application number: PCT/JP2023/032937
(87) International publication number: WO 2024/058084

(57) **Abstract**

A cable management system manages a cable, and the cable management system includes a mobile terminal and a server. The server includes a storage unit configured to store cable information including information on the cable. The mobile terminal includes: means configured to transmit identification information of the cable to the server, the identification information of the cable being assigned to a storage member configured to store the cable; and means configured to display the cable information transmitted from the server. The server includes: means configured to extract the cable information from the storage unit, based on the identification information transmitted from the mobile terminal; and means configured to transmit the extracted cable information to the mobile terminal.

## Description

### TECHNICAL FIELD

The present disclosure relates to a cable management system and a cable management method.

This application claims priority to Japanese Patent Application No. 2022-144804 filed on September 12, 2022, the entire contents of which are incorporated herein by reference.

### BACKGROUND ART

Cables, such as optical cables and power cables, are wound around drums or the like to be stored, for example.

Patent literature 1 discloses a shipment management system for managing shipment of a cable wound around a storage drum. Patent literature 1 discloses that the shipment management system includes code data reading means for reading code data from the storage drum to which the code data storing information on an identification number of the storage drum and a length of a cable wound around the storage drum is attached. Patent literature 1 also discloses that the shipment management system includes cutting error determination means for comparing an accepted winding length with a cutting length stored in read work instruction information and determining at least a cutting error based on a difference between the winding length and the cutting length.

Patent literature 2 discloses a cable construction management system that includes a work terminal carried by a worker and a management terminal capable of providing work information on cable construction to the work terminal, and that manages cable construction based on the work information. Patent literature 2 discloses that the work terminal includes a camera unit capable of reading markers of a cable construction card, a drum, and a terminal block.

### CITATION LIST

### PATENT LITERATURE

Patent literature 1: Japanese Unexamined Patent Application Publication No. 2007-079907
Patent literature 2: Japanese Unexamined Patent Application Publication No. 2018-147440

### SUMMARY OF INVENTION

A cable management system according to present disclosure is a cable management system for managing a cable. The cable management system includes a mobile terminal and a server. The server includes a storage unit configured to store cable information including information on the cable. The mobile terminal includes means configured to transmit, to the server, identification information of the cable that is assigned to a storage member configured to store the cable, and means configured to display the cable information transmitted from the server. The server includes means configured to extract the cable information from the storage unit, based on the identification information transmitted from the mobile terminal, and means configured to transmit the extracted cable information to the mobile terminal.

### BRIEF DESCRIPTION OF THE DRAWINGS

[FIG. 1] FIG. 1 is a schematic diagram of a configuration of a cable management system according to the present embodiment.
[FIG. 2] FIG. 2 is a diagram illustrating a hardware configuration of a mobile terminal in the cable management system according to the present embodiment.
[FIG. 3] FIG. 3 is a diagram illustrating a hardware configuration of a server in the cable management system according to the present embodiment.
[FIG. 4] FIG. 4 is a diagram illustrating a functional configuration of the cable management system according to the present embodiment.
[FIG. 5] FIG. 5 is a flowchart illustrating processing in the cable management system according to the present embodiment.
[FIG. 6] FIG. 6 is a flowchart illustrating processing in the cable management system according to the present embodiment.
[FIG. 7] FIG. 7 is a flowchart illustrating processing in the cable management system according to the present embodiment.

### DETAILED DESCRIPTION

### [Problems to be Solved by Present Disclosure]

A purchaser who has purchased a cable is required to appropriately manage the owned cable. For example, the purchaser is required to appropriately manage a remaining length, a storage location, and the like of the cable.

A seller who has sold cables is required to make a more accurate sales plan by grasping the inventory status of the sold cables. The seller makes a more accurate sales plan, and thus can avoid a situation of having an excessive inventory based on an excessive outlook for demand.

The present disclosure provides a cable management system that enables information on a cable to be shared between a purchaser and a seller.

### [Advantageous Effects of Present Disclosure]

According to the cable management system of the present disclosure, information on a cable can be shared between a purchaser and a seller.

### [Description of Embodiments of Present Disclosure]

First, embodiments of the present disclosure will be listed and described.
(1) A cable management system of present disclosure is a cable management system for managing a cable. The cable management system includes a mobile terminal and a server. The server includes a storage unit configured to store cable information including information on the cable. The mobile terminal includes means configured to transmit, to the server, identification information of the cable that is assigned to a storage member configured to store the cable, and means configured to display the cable information transmitted from the server. The server includes means configured to extract the cable information from the storage unit, based on the identification information transmitted from the mobile terminal, and means configured to transmit the extracted cable information to the mobile terminal.
   According to the cable management system of the present disclosure, the information on the cable can be shared between a purchaser and a seller.
(2) In the above (1), the cable information includes a product name of the cable and a cable length at a time of shipment.
   According to the cable management system disclosed in the above (2), information on the product name of the cable purchased by the purchaser and the cable length at a time of shipment can be shared between the purchaser and the seller.
(3) In the above (1) or (2), the storage member is provided with an identification mark including the identification information. The mobile terminal further includes means configured to capture an image of the identification mark, and means configured to extract the identification information from the captured image of the identification mark.
   According to the cable management system disclosed in the above (3), the information on the cable can be shared between the purchaser and the seller. According to the cable management system disclosed in the above (3), it is possible to automate the input of identification information.
(4) In any one of the above (1) to (3), the server stores usage information including information on usage of the cable in the storage unit. The usage information includes a remaining cable length. The mobile terminal further includes means configured to capture an image of a length mark near a top end of the cable, means configured to extract length information from the captured image of the length mark, and means configured to transmit the extracted length information to the server. The server further includes means configured to update the remaining cable length in the usage information, based on the length information having been received.
   According to the cable management system disclosed in the above (4), the information on the cable can be shared between the purchaser and the seller. According to the cable management system disclosed in the above (4), it is possible to automate the input of the remaining cable length.
(5) In the above (4), the usage information includes position information. The mobile terminal further executes means configured to perform position measurement in vicinity of the storage member, and means configured to transmit a positioning result obtained by the position measurement to the server. The server further includes means configured to update the position information in the usage information, based on the positioning result having been received.
   According to the cable management system disclosed in the above (5), the information on the cable can be shared between the purchaser and the seller. According to the cable management system disclosed in the above (5), it is possible to automate the input of position information of the cable.
(6) In the above (4) or (5), the server displays an inventory of a purchaser having purchased the cable, based on the usage information.
   According to the cable management system disclosed in the above (6), information on the inventory of the cable can be shared between the purchaser and the seller.
(7) In the above (1) to (6), the cable information further includes specification information, an installation instruction, shipment data, and inspection data.
   According to the cable management system disclosed in the above (7), information on the specification information, the installation instruction, the shipment data, and the inspection data of the cable purchased by the purchaser can be shared between the purchaser and the seller.
(8) In the above (1) to (7), the cable information includes content of a trouble.
   According to the cable management system disclosed in the above (8), information on the trouble of the cable purchased by the purchaser can be shared between the purchaser and the seller.
(9) In the above (1) to (8), the storage member is a cable drum.
   According to the cable management system disclosed in the above (9), the information on the cable delivered to a purchaser using a cable drum can be shared between the purchaser and a seller.
(10) In the above (1) to (8), the storage member is a box.
   According to the cable management system disclosed in the above (10), the information on the cable delivered to a purchaser using a box can be shared between the purchaser and a seller.
(11) A cable management method of the present disclosure is a cable management method using a cable management system including a mobile terminal and a server. The server includes a storage unit configured to store cable information including information on a cable. The mobile terminal executes transmitting, to the server, identification information of the cable that is assigned to a storage member configured to store the cable and displaying the cable information transmitted from the server. The server executes extracting the cable information from the storage unit, based on the identification information transmitted from the mobile terminal, and transmitting the extracted cable information to the mobile terminal.

According to the cable management method of the present disclosure, the information on the cable can be shared between a purchaser and a seller.

### [Details of Embodiments of Present Disclosure]

Specific examples of a cable management system and a cable management method of the present disclosure will be described below with reference to the drawings. The present invention is not limited to these examples, but is defined by the scope of the claims, and is intended to include all modifications within the meaning and scope equivalent to the scope of the claims.

In the description of the specification and the drawings according to each embodiment, components having substantially the same or corresponding functions are denoted by the same reference numerals, and redundant description thereof may be omitted. In addition, for ease of understanding, the scale of each part in the drawings may be different from the actual scale.

The embodiments will be described below, but at least some of the embodiments described below may be combined as desired.

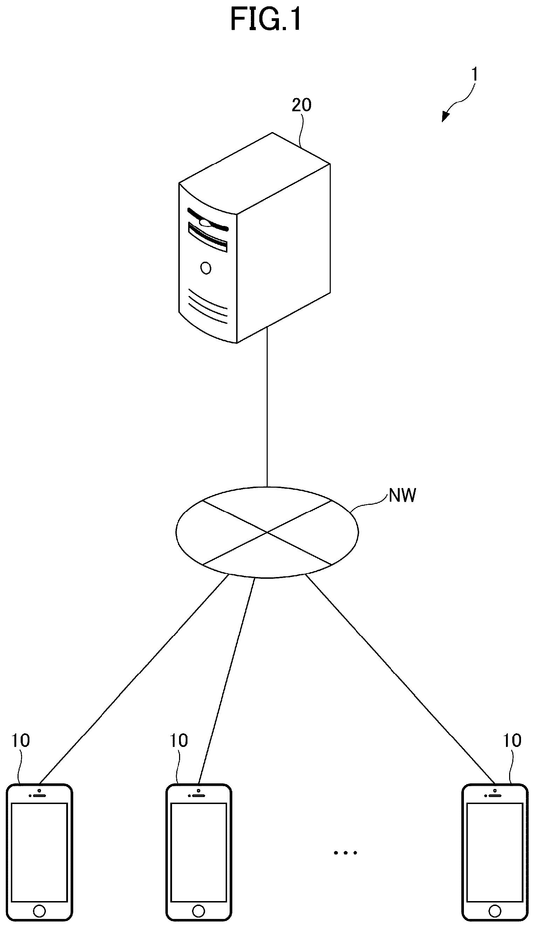

A cable management system according to the embodiment will be described. FIG. 1 is a schematic diagram of a configuration of a cable management system 1 according to the present embodiment. Cable management system 1 according to the present embodiment manages a remaining cable length and a storage location of an optical cable, a power cable or the like. Cable management system 1 according to the present embodiment includes at least one mobile terminal 10 and a server 20.

### [Mobile Terminal 10]

Mobile terminal 10 is, for example, a smartphone or a tablet computer. Mobile terminal 10 is used by a purchaser who has purchased a cable. Mobile terminal 10 executes an application provided by a seller who has sold the cable. Mobile terminal 10 is connected to server 20 via a network NW. Mobile terminal 10 exchanges data with server 20 using an application executed in mobile terminal 10.

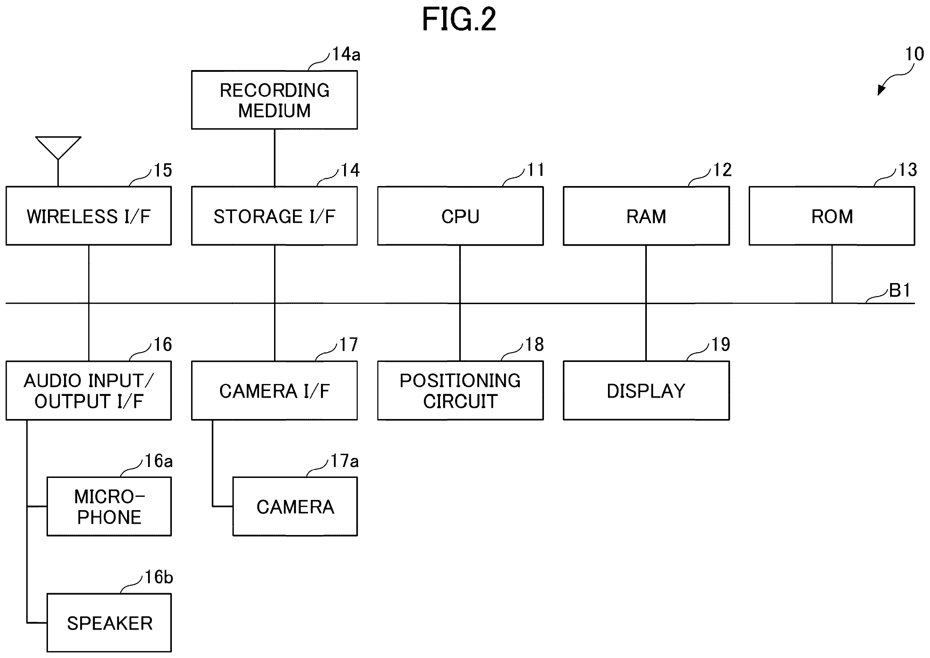

Mobile terminal 10 is implemented by, for example, a mobile terminal having a hardware configuration illustrated in FIG. 2. FIG. 2 is a diagram illustrating the hardware of mobile terminal 10 in cable management system 1 according the present embodiment.

Mobile terminal 10 includes a central processing unit (CPU) 11, a random access memory (RAM) 12, and a read only memory (ROM) 13. Mobile terminal 10 further includes a storage interface (I/F) 14, a wireless I/F 15, an audio input/output I/F 16, a camera I/F 17, a positioning circuit 18, and a display 19. Each of CPU 11, RAM 12, ROM 13, storage I/F 14, wireless I/F 15, audio input/output I/F 16, camera I/F 17, positioning circuit 18, and display 19 is connected to a bus B1.

For example, a recording medium 14a is connected to storage I/F 14. A microphone 16a and a speaker 16b are connected to audio input/output I/F 16.

CPU 11 is an arithmetic device that reads a program (application) from a storage device, such as ROM 13 or recording medium 14a onto RAM 12, and executes processing.

RAM 12 is a volatile semiconductor memory that temporarily stores, for example, a program (application) and the like.

ROM 13 is, for example, a nonvolatile semiconductor memory that can hold a program (application) or the like even when the power is turned off. ROM 13 stores a program, such as a basic input/output system (BIOS), executed at a time of activation, and various settings, such as an operating system (OS) setting and a network setting.

Storage I/F 14 is an interface with an external device, such as recording medium 14a. Mobile terminal 10 illustrated in FIG. 2 can read and write data from and to recording medium 14a by using storage I/F 14.

Recording medium 14a is, for example, a secure digital (SD) memory card or a universal serial bus (USB) memory.

Wireless I/F 15 is an interface for wirelessly connecting to an external network, such as a wireless local area network (LAN) or the Internet. Wireless I/F 15 includes an antenna and connects to an external network using a mobile communication method, such as long term evolution (LTE). Wireless I/F 15 connects to an external network using a wireless communication method, such as a wireless local area network (LAN) or Bluetooth (registered trademark). Mobile terminal 10 communicates with server 20 by using wireless I/F 15. Mobile terminal 10 may be connected to server 20 using a wired communication method, for example.

Audio input/output I/F 16 performs processing of inputting and outputting audio and the like. Microphone 16a and speaker 16b are connected to audio input/output I/F 16. Audio input/output I/F 16 inputs audio and the like from microphone 16a. Audio input/output I/F 16 outputs audio and the like from speaker 16b.

Camera I/F 17 performs processing of inputting an image. A camera 17a is connected to camera I/F 17. Camera 17a is a camera included in mobile terminal 10.

Positioning circuit 18 measures the position of mobile terminal 10. Positioning circuit 18 is, for example, a global navigation satellite system (GNSS) receiver. The GNSS receiver receives a positioning signal from a GNSS satellite represented by a global positioning system (GPS) satellite to acquire position information of mobile terminal 10.

Display 19 is a display having a touch panel. Display 19 displays a user interface (UI), information, and the like. Display 19 detects a touch on the screen to input an operation or the like.

Mobile terminal 10 according to the present embodiment executes a program (application) in the above-described hardware configuration to perform various processing described later.

### [Server 20]

Server 20 is, for example, a computer. Server 20 is used by a seller who has sold the cable. Server 20 is connected to each of mobile terminals 10 via network NW. Server 20 exchanges data with each of mobile terminals 10 using a program executed in server 20.

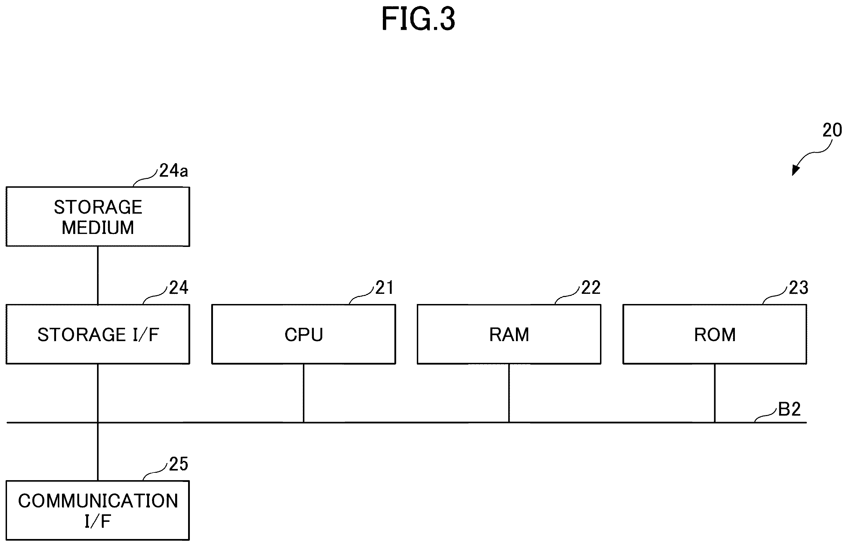

Server 20 is implemented by, for example, a computer having a hardware configuration illustrated in FIG. 3. FIG. 3 is a diagram illustrating a hardware of server 20 in cable management system 1 according to the present embodiment.

Server 20 includes a CPU 21, a RAM 22, a ROM 23, a storage I/F 24, and a communication I/F 25. Each of CPU 21, RAM 22, ROM 23, storage I/F 24, and communication I/F 25 is connected to a bus B2. For example, a storage medium 24a is connected to storage I/F 24.

CPU 21 is an arithmetic device that reads a program (application) from a storage device, such as ROM 23 or storage medium 24a, onto RAM 22 and executes processing.

RAM 22 is, for example, a volatile semiconductor memory that temporarily stores a program (application) and the like.

ROM 23 is, for example, a nonvolatile semiconductor memory that can hold a program (application) or the like even when the power is turned off. ROM 23 stores a program, such as a BIOS, executed at startup, and various settings, such as an OS setting and a network setting.

Storage I/F 24 is an interface with an external device, such as storage medium 24a. Mobile terminal 10 illustrated in FIG. 2 can read and write data from and to storage medium 24a by using storage I/F 24.

Storage medium 24a is, for example, a hard disk drive (HDD) or a solid state drive (SSD) .

Communication I/F 25 is an interface that connects to an external network, such as the Internet. Communication I/F 25 connects to an external network using a wired communication method, for example. Server 20 can communicate with each of mobile terminals 10 using communication I/F 25.

Server 20 according to the present embodiment executes a program (application) in the above-described hardware configuration to perform various processing described later.

### <Identification Information>

Cable management system 1 uses identification information to manage each cable to be shipped. The identification information is, for example, a character string composed of a plurality of characters including numerals and alphabets. The identification information is uniquely assigned to each cable to be shipped.

The identification information is assigned to, for example, a cable drum, which is an example of a storage member used when storing a cable. In order to display the identification information on the cable drum, for example, a character string may be printed on the cable drum, or a seal on which a character string is printed may be attached to the cable drum. In order to display the identification information on the cable drum, an encoded identification mark, such as a one dimensional barcode or a two dimensional barcode, may be assigned to the cable drum instead of the character string.

The identification information may be stored in an electronic tag. The electronic tag is also referred to as, for example, an integrated circuit (IC) tag, a wireless tag, or a radio frequency identification (RFID). When the identification information is stored in the electronic tag, the electronic tag is attached to a cable drum, which is an example of a storage member used when storing a cable. When the identification information is stored in the electronic tag, mobile terminal 10 has a function of reading the electronic tag.

### <Functional Configuration of Cable Management System 1>

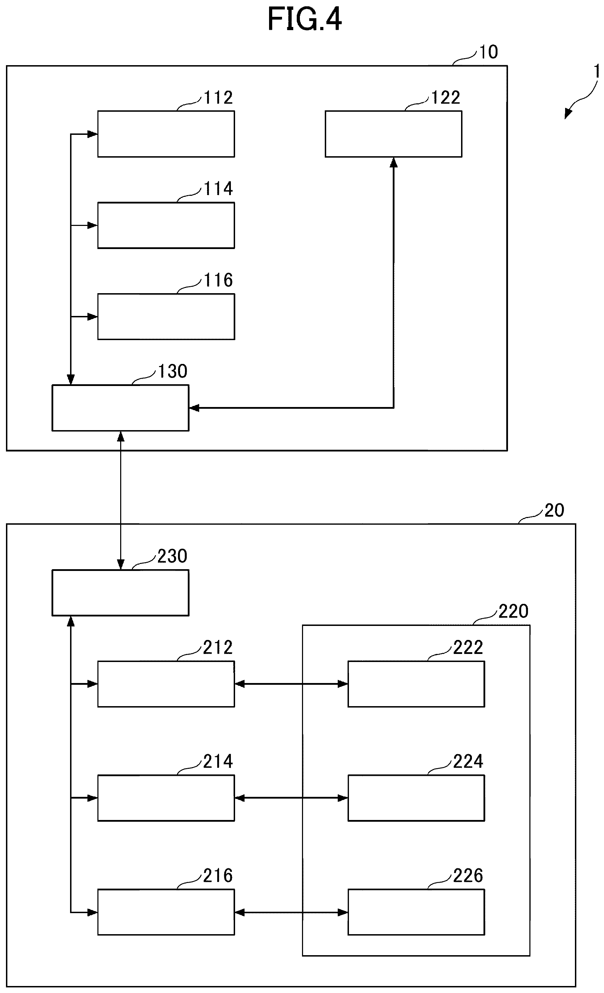

A functional configuration of cable management system 1 according to the present embodiment will be described. FIG. 4 is a diagram illustrating the functional configuration of cable management system 1 according to the present embodiment.

Mobile terminal 10 in cable management system 1 includes an identification information input unit 112, a cable length input unit 114, a storage location information input unit 116, a screen display unit 122, and a communication unit 130.

### [Identification Information Input Unit 112]

Identification information input unit 112 inputs identification information assigned to a cable drum. Identification information input unit 112 outputs the input identification information to communication unit 130.

CPU 11 executes a program, and thereby identification information input unit 112 functions. Identification information input unit 112 is implemented by, for example, CPU 11 controlling display 19 so as to display an instruction to input identification information on the screen of display 19 and extracting a character string input in a text box. Identification information input unit 112 is implemented by, for example, CPU 11 encoding an image obtained by capturing an image of an identification mark attached to a cable drum with camera 17a.

Furthermore, identification information input unit 112 may read the identification information stored in an electronic tag attached to a cable drum, for example, to input the identification information.

### [Cable Length Input Unit 114]

Cable length input unit 114 inputs a cable length of a cable. Cable length input unit 114 outputs the input cable length to communication unit 130.

CPU 11 executes a program, and thereby cable length input unit 114 functions. Cable length input unit 114 is implemented, for example, by CPU 11 controlling display 19 so as to display an instruction to input the cable length on the screen of display 19 and extracting a character string input in a text box. Cable length input unit 114 is implemented by, for example, CPU 11 encoding an image obtained by capturing an image of a length mark attached to a cable with camera 17a.

### [Storage Location Information Input Unit 116]

Storage location information input unit 116 inputs storage location information indicating where a cable drum is placed. Storage location information input unit 116 outputs the input storage location information to communication unit 130.

CPU 11 executes a program, and thereby storage location information input unit 116 functions. Storage location information input unit 116 is implemented, for example, by CPU 11 controlling display 19 so as to display an instruction to input the position of the storage place for a cable drum on display 19 and extracting a character string input in a text box. Storage location information input unit 116 is implemented by, for example, CPU 11 controlling positioning circuit 18 so as to measure the position.

Furthermore, storage location information input unit 116 may read a barcode or an electronic tag to input the storage location information. In reading the barcode or the electronic tag, the barcode for displaying the storage location information or the electronic tag for storing the storage location information is installed in a storage place. Storage location information input unit 116 may read the barcode or the electronic tag with mobile terminal 10 to register the storage location information. The storage location information is, for example, a shelf number or a shelf address.

### [Screen Display unit 122]

Screen display unit 122 displays information acquired from server 20. Screen display unit 122 acquires the information transmitted from server 20 from communication unit 130.

CPU 11 executes a program, and thereby screen display unit 122 functions. Screen display unit 122 is implemented by, for example, CPU 11 controlling display 19 so as to display information transmitted from server 20.

### [Communication Unit 130]

Communication unit 130 communicates with server 20. CPU 11 executes a program, and thereby communication unit 130 functions. Communication unit 130 is implemented by, for example, CPU 11 controlling wireless I/F 15 so that wireless I/F 15 transmits and receives data.

Server 20 in cable management system 1 includes a cable shipment information operation unit 212, a cable usage information operation unit 214, a cable-related information operation unit 216, a storage unit 220, and a communication unit 230. Storage unit 220 includes a cable shipment information database 222, a cable usage information database 224, and a cable-related information database 226.

Here, information stored in storage unit 220 and managed by server 20 will be described. Server 20 stores cable shipment information, cable usage information, and cable-related information in cable shipment information database 222, cable usage information database 224, and cable-related information database 226, respectively, as databases. The cable shipment information, the cable usage information, and the cable-related information may be collectively referred to as cable information. The cable information includes information on a cable. Although the items of the cable information are exemplified below by exemplifying the items included in each of the cable shipment information, the cable usage information, and the cable-related information, the cable information may include items related to the cable other than the items listed below.

### (Cable Shipment Information)

Cable shipment information stored in cable shipment information database 222 by server 20 will be described. Table 1 indicates cable shipment information. The cable shipment information includes information on a cable sold by a seller and purchased by a purchaser. The cable shipment information includes information on the cable when the cable is shipped. The cable shipment information includes, for example, a product name of the cable, a cable length at a time of shipment (shipment cable length, shipping length), shipment data, and inspection data. The cable shipment information is stored in cable shipment information database 222 using the identification information as a key. In Table 1, data are indicated by asterisks as samples.

**[Table 1]**

| CABLE SHIPMENT INFORMATION | | | | |
|---|---|---|---|---|
| IDENTIFCA-TION INFORMATION | PRODUCT NAME | SHIPMENT CABLE LENGTH | SHIPMENT DATA | INSPECTION DATA |
| ***** | ***** | *** | ***** | ***** |
| ***** | ***** | *** | ***** | ***** |
| ***** | ***** | *** | ***** | ***** |
| ***** | ***** | *** | ***** | ***** |
| ***** | ***** | *** | ***** | ***** |

### (Product Name)

Product name is a product name of a cable stored in a cable drum to which the identification information is assigned. The product name is composed of a character string.

### (Shipment Cable Length)

Shipment cable length is a length of a cable stored in a cable drum to which the identification information at a time of shipment is assigned. The shipment cable length is also referred to as a shipping length.

### (Shipment Data)

Shipment data is, for example, information related to shipment of a cable drum. The shipment data includes, for example, a shipment date, a ship origin, and a shipment destination.

### (Inspection Data)

Inspection data is, for example, inspection data obtained when a shipment inspection is performed on a cable stored in a cable drum. The inspection data includes, for example, results of a dimensional inspection and an electrical test in a shipping test.

Each of the product name, the shipment cable length, the shipment data, and the inspection data included in the cable shipment information is merely an example, and the cable shipment information may include items related to the shipment of the cable other than the above.

### (Cable Usage Information)

Cable usage information stored in cable usage information database 224 by server 20 will be described. Table 2 indicates cable usage information. The cable usage information includes information on usage of a cable sold by a seller and purchased by a purchaser. The cable usage information includes, for example, the remaining length of a cable remaining in a cable drum and the storage location information of the cable drum. The cable usage information is stored in cable usage information database 224 using the identification information as a key. In Table 2, data are indicated by asterisks as samples.

**[Table 2]**

| **USAGE INFORMATION** | | |
|---|---|---|
| **IDENTIFICATION INFORMATION** | **REMAINING CABLE LENGTH** | **STORAGE LOCATION INFORMATION** |
| ***** | ***** | ***** |
| ***** | ***** | ***** |
| ***** | ***** | ***** |
| ***** | ***** | ***** |
| ***** | ***** | ***** |

### (Remaining Cable Length)

Remaining cable length is a cable length, at the current time, of a cable stored in a cable drum to which the identification information is assigned.

### (Storage Location Information)

Storage location information is information on a location where a cable drum to which the identification information is assigned is placed. The storage location information is, for example, position information or shelf information based on latitude and longitude.

Each of the remaining cable length and the storage location information included in the cable usage information described above is merely an example, and the cable usage information may include items related to the usage of the cable other than the above.

### (Cable-Related Information)

Cable-related information stored in cable-related information database 226 by server 20 will be described. Table 3 indicates cable-related information. The cable-related information includes information related to a cable sold by a seller and purchased by a purchaser. The cable-related information includes, for example, specification information, an installation instruction sheet, and trouble information of the cable. The cable-related information is stored in cable-related information database 226 using the product name as a key. In Table 3, data are indicated by asterisks as samples.

**Table 3**

| CABLE-RELATED INFORMATION | | | |
|---|---|---|---|
| PRODUCT NAME | SPECIFICATION INFORMATION | INSTALLATION INSTRUCTION SHEET | TROUBLE INFORMATION |
| ***** | ***** | ***** | ***** |
| ***** | ***** | ***** | ***** |
| ***** | ***** | ***** | ***** |
| ***** | ***** | ***** | ***** |
| ***** | ***** | ***** | ***** |

### (Specification Information)

Specification information is information indicating a specification of a cable stored in a cable drum to which the identification information is assigned. The specification information may refer to a data sheet of the cable or may provide a duplicated data sheet of the cable, for example.

### (Installation Instruction Sheet)

An installation instruction sheet is determined for each type of cable and includes information on a procedure for installing a cable. The installation instruction sheet may be, for example, a file in which the procedure is described. The installation instruction sheet is an example of an installation instruction.

### (Trouble Information)

Trouble information is information on a trouble collected for each type of cable.

Each of the specification information, the installation instruction sheet, and the trouble information included in the cable-related information described above is merely an example, and the cable-related information may include other cable-related items.

### [Cable Shipment Information Operation Unit 212]

Cable shipment information operation unit 212 operates data stored in cable shipment information database 222. Cable shipment information operation unit 212 outputs the cable shipment information that matches the identification information to communication unit 230, for example, using the identification information as a key.

CPU 21 executes a program, and thereby cable shipment information operation unit 212 functions. Cable shipment information operation unit 212 is implemented by, for example, CPU 21 extracting the cable shipment information that matches the identification information from cable shipment information database 222.

### [Cable Usage Information Operation Unit 214]

Cable usage information operation unit 214 operates data stored in cable usage information database 224. Cable usage information operation unit 214 operates the cable usage information that matches the identification information, for example, using the identification information as a key.

CPU 21 executes a program, and thereby cable usage information operation unit 214 functions. Cable usage information operation unit 214 is implemented by, for example, CPU 21 extracting the cable usage information that matches the identification information from cable usage information database 224. Cable usage information operation unit 214 is implemented by, for example, CPU 21 updating the cable usage information that matches the identification information from cable usage information database 224.

### [Cable-related Information Operation Unit 216]

Cable-related information operation unit 216 operates data stored in cable-related information database 226. Cable-related information operation unit 216 operates cable-related information that matches the product name, for example, using the product name as a key.

CPU 21 executes a program, and thereby cable-related information operation unit 216 functions. Cable-related information operation unit 216 is implemented by, for example, CPU 21 extracting the cable-related information that matches the product name from cable-related information database 226. Cable-related information operation unit 216 is implemented by, for example, CPU 21 updating the cable-related information that matches the product name from cable-related information database 226.

### [Communication Unit 230]

Communication unit 230 communicates with mobile terminal 10. CPU 21 executes a program, and thereby communication unit 230 functions. Communication unit 230 is implemented by, for example, CPU 21 controlling communication I/F 25 such that communication I/F 25 transmits and receives data.

### <Processing in Cable Management System 1>

The processing in cable management system 1 according to the present embodiment will be described. The respective means of the cable management method will be described by describing the processing of cable management system 1 according to the present embodiment. As examples of the processing in cable management system 1, acquisition of cable shipment information, update of cable length information, and update of storage location information will be described.

### [Acquisition of Cable Shipment Information]

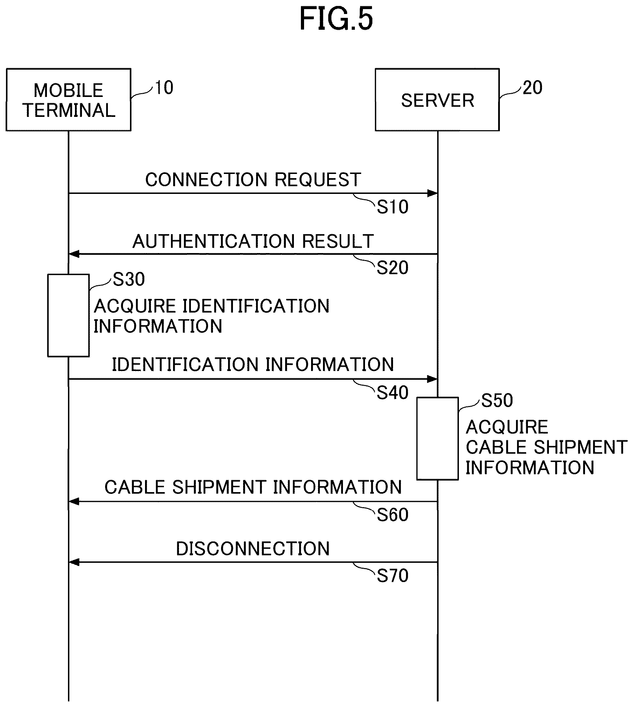

FIG. 5 is a diagram illustrating processing of acquiring cable shipment information in cable management system 1 according to the present embodiment. In the processing illustrated in FIG. 5, mobile terminal 10 acquires the cable shipment information from server 20.

### (Step S10)

First, mobile terminal 10 transmits a connection request to server 20.

### (Step S20)

Server 20 confirms whether mobile terminal 10 has the authority to connect to server 20. When mobile terminal 10 has the authority to connect to server 20, server 20 transmits an authentication result indicating that the connection is permitted. When mobile terminal 10 does not have the authority to connect to server 20, server 20 transmits an authentication result indicating that the connection is rejected. When the connection is rejected, mobile terminal 10 terminates the processing without performing processing of step S30. Here, it is considered for a case where mobile terminal 10 has the authority.

### (Step S30)

Mobile terminal 10 acquires the identification information assigned to a cable drum. An operator of mobile terminal 10 may input the identification information assigned to the cable drum into a text box in the application of mobile terminal 10, for example. In addition, when the identification information assigned to the cable drum is provided using a two dimensional barcode, the operator of mobile terminal 10 may capture an image of the two dimensional barcode with camera 17a of mobile terminal 10. When the image of the two dimensional barcode is captured, mobile terminal 10 extracts the identification information from the captured image of the two dimensional barcode.

### (Step S40)

Next, mobile terminal 10 transmits the identification information to server 20.

### (Step S50)

Server 20 extracts the cable shipment information that matches the identification information transmitted from mobile terminal 10 from the cable shipment information database stored in the storage unit.

### (Step S60)

Server 20 transmits the cable shipment information that matches the identification information acquired in step S50 to mobile terminal 10. Mobile terminal 10 displays the transmitted cable shipment information on, for example, display 19.

### (Step S70)

Server 20 finishes the communication with mobile terminal 10.

Although the cable shipment information has been described above, server 20 may transmit the cable usage information or the cable-related information when mobile terminal 10 transmits the identification information, for example. Mobile terminal 10 displays the cable usage information or the cable-related information transmitted from server 20 on display 19. In other words, in cable management system 1, when mobile terminal 10 transmits the identification information, any of the cable information, which is information on the cable, may be transmitted from server 20.

### [Update of Cable Length Information]

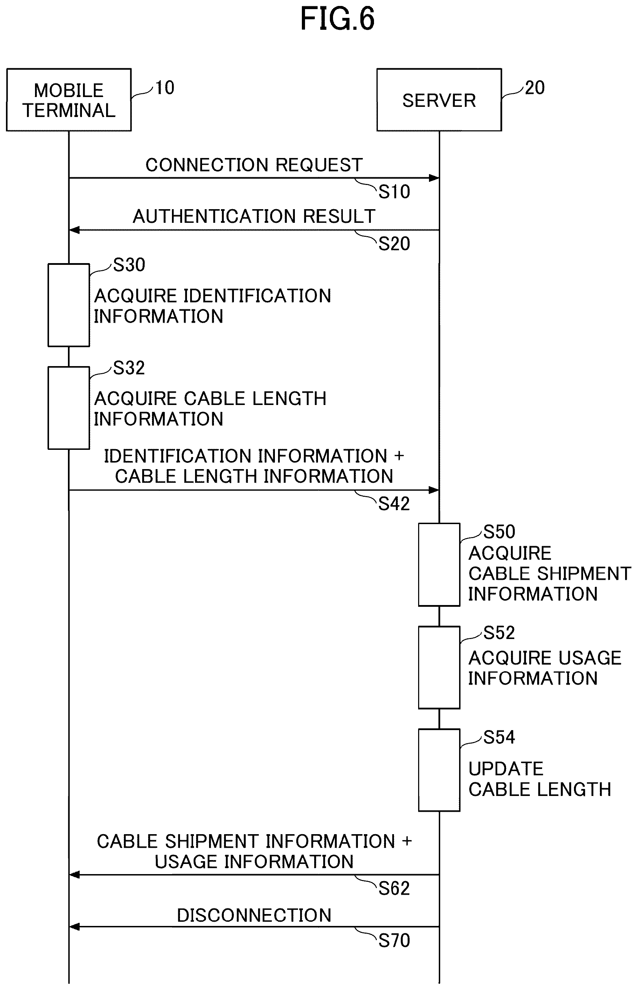

FIG. 6 is a diagram illustrating processing of updating cable length information in cable management system 1 according to the present embodiment. In the processing illustrated in FIG. 6, mobile terminal 10 transmits the cable length information to server 20. Then, mobile terminal 10 acquires the cable shipment information and the cable usage information from server 20.

The above description is referred to for step S10, step S20, step S30, step S50, and step S70, and the description thereof is omitted here.

### (Step S32)

Mobile terminal 10 acquires the cable length information of the cable wound around the cable drum. The operator of mobile terminal 10 may input the numerical value of the length mark closest to the end of the cable, in other words, the length mark near the top end, in a text box in the application of mobile terminal 10, for example. The operator of mobile terminal 10 may capture an image of the length mark closest to the end of the cable with camera 17a of mobile terminal 10. Mobile terminal 10 analyzes the captured image and extracts the cable length information of the cable.

When mobile terminal 10 captures an image of the length mark, the captured image may be transmitted to server 20. Server 20 may store the captured image. By storing the captured image in server 20, the image can be left as a record and the validity of the data can be verified later. Furthermore, server 20 may analyze the transmitted image to extract the cable length information of the cable.

### (Step S42)

Next, mobile terminal 10 transmits the identification information and the cable length information to server 20.

### (Step S52)

Server 20 extracts the cable usage information that matches the identification information transmitted from mobile terminal 10 from the cable usage information database stored in the storage unit.

### (Step S54)

Server 20 updates the cable length information in the extracted cable usage information based on the cable length information transmitted and received from mobile terminal 10. Server 20 stores the updated cable usage information in the cable usage information database stored in the storage unit.

### (Step S62)

Server 20 transmits the cable shipment information that matches the identification information acquired in step S50, and the cable usage information updated in step S54 to mobile terminal 10. Mobile terminal 10 displays the transmitted cable shipment information and usage information on, for example, display 19.

### [Update of Storage Location Information]

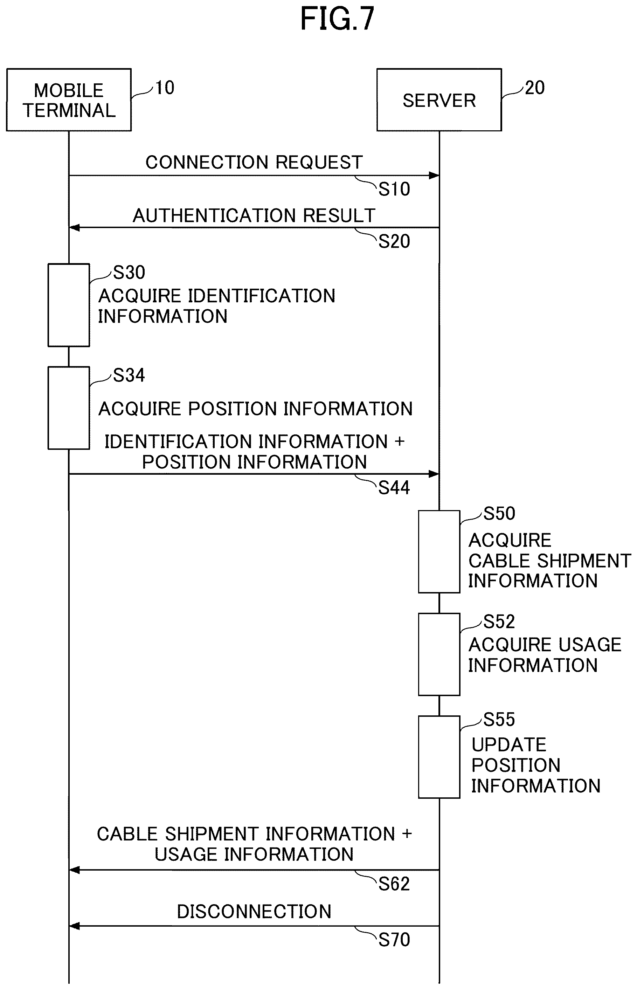

FIG. 7 is a diagram illustrating processing of updating storage location information in cable management system 1 according to the present embodiment. In the processing illustrated in FIG. 7, mobile terminal 10 transmits the position information of the storage place to server 20. Then, mobile terminal 10 acquires the cable shipment information and the cable usage information from server 20.

The above description is referred to for step S10, step S20, step S30, step S50, step S52, and step S70, and the description thereof is omitted here.

### (Step S34)

Mobile terminal 10 acquires position information that is information on the position of the storage place for the cable drum. The operator of mobile terminal 10 may input information on a place, for example, information indicating a position, such as coordinates, or information indicating a place, such as a shelf number, for example, in a text box in an application of mobile terminal 10. The operator of mobile terminal 10 may capture an image of the cable drum with camera 17a of mobile terminal 10. Furthermore, the operator of mobile terminal 10 may measure the position of mobile terminal 10 (position measurement) with positioning circuit 18 in mobile terminal 10 in the vicinity of the cable drum, and acquire the position of mobile terminal 10, which is the positioning result, as the position of the cable drum.

When the image of the cable drum is captured using mobile terminal 10, the captured image may be transmitted to server 20. Server 20 may store the captured image. By storing the captured image in server 20, the image can be left as a record and the validity of the data can be verified later.

### (Step S44)

Next, mobile terminal 10 transmits the identification information and the position information to server 20.

### (Step S55)

Server 20 updates the storage location information in the extracted cable usage information based on the position information transmitted from mobile terminal 10. Server 20 stores the updated cable usage information in the cable usage information database stored in the storage unit.

### (Step S62)

Server 20 transmits the cable shipment information that matches the identification information acquired in step S50, and the cable usage information updated in step S55 to mobile terminal 10. Mobile terminal 10 displays the transmitted cable shipment information and usage information on, for example, display 19.

According to cable management system 1 of the present embodiment, information on a cable can be shared between a purchaser and a seller of a cable.

According to cable management system 1 of the present embodiment, the purchaser can grasp the status of the inventory. Furthermore, according to cable management system 1 of the present embodiment, it is possible to reduce the time and effort taken for managing the usage status of the owned cable (remaining cable length or storage place). Furthermore, according to cable management system 1 of the present embodiment, it is possible to reduce recording errors or transcription errors.

According to cable management system 1 of the present embodiment, the seller can grasp the status of the inventory of the purchaser. In addition, according to cable management system 1 of the present embodiment, when an empty cable drum after the cable has been used is collected and reused, the seller and the purchaser can accurately grasp the presence or absence of the empty cable drum. Furthermore, according to cable management system 1 of the present embodiment, since the empty cable drum can be collected quickly, the frequency of procuring a new cable drum can be reduced, and the cost can be suppressed.

At a cable installation site, after a cable has been used, the product number of the cable, the length of the cable used, and the storage place after use, have been recorded and reported to a site manager or a material manager. The site manager or the material manager then updates and manages the database regarding the remaining length, the storage place, and the like of the owned cable each time.

Furthermore, since the cable seller cannot know the status of the usage of the cable sold to the customer, the cable seller has to rely on interviews with a material staff of the purchaser for having the outlook for future demand. In addition, the cable seller sometimes collects and reuses an empty cable drum after the purchaser has used a cable. In that case, the cable seller has to rely on interviews with a material staff of the customer for information on the presence or absence of the empty cable drum and the storage place of the empty cable drum.

It is difficult to collect all empty cable drums. In particular, for exported products, it is difficult to collect empty cable drums. A storage period until the cable purchaser has used up the purchased cable may also be long. Thus, it is desired to avoid installing a sensor or the like, which leads to an increase in cost and is battery dependent, in a cable or a cable drum.

Thus, according to cable management system 1 of the present embodiment, the cable purchaser can view the shipping information (product name, shipping length, etc.) on the cable from the database of server 20 by inputting the identification number of the cable on the application. Furthermore, according to cable management system 1 of the present embodiment, the input can be automated by reading the two dimensional barcode attached to the cable drum.

According to cable management system 1 of the present embodiment, the cable purchaser can input the remaining length and the storage location of the cable on the application after using the cable, and upload the remaining length and the storage location to the database. Furthermore, according to cable management system 1 of the present embodiment, the site manager or the material manager of the cable purchaser can view the database. According to cable management system 1 of the present embodiment, the latest usage information (remaining length, storage place (storage location)) of the owned cable can be confirmed at any time. In cable management system 1, information shared between the seller and the purchaser may be selected as appropriate.

When registering the remaining cable length in mobile terminal 10, cable management system 1 according to the present embodiment can automatically read the length mark at the top end after cutting the cable, using camera 17a in mobile terminal 10. In addition, cable management system 1 according to the present embodiment can manually input the remaining cable length. The remaining cable length can be calculated by comparing the length mark with, for example, the length information at the top and bottom ends at a time of shipment. Furthermore, according to cable management system 1 of the present embodiment, it is possible to prevent an input error by automatic reading with the camera function. In addition, according to cable management system 1 of the present embodiment, the record can be checked by storing the photograph of the length mark on server 20.

According to cable management system 1 of the present embodiment, when the storage location of the cable is registered in mobile terminal 10, the coordinates can be registered using the positioning function of mobile terminal 10. Furthermore, according to cable management system 1 of the present embodiment, the layout of the storage place and the like can be stored as a photograph.

According to cable management system 1 of the present embodiment, the seller shares the information in the database with permission of the purchaser, and thus the seller can confirm the inventory holding status of the customer and use the inventory holding status to forecast demand. Furthermore, the seller shares the information in the database with permission of the purchaser, and thus, for example, the seller can promptly catch an inventory decrease and cope with a rapid increase in demand after the inventory has decreased.

According to cable management system 1 of the present embodiment, the seller or the purchaser can grasp the quantity and the storage location of the empty cable drum based on the remaining length information of the cable drum and efficiently collect the empty cable drum.

According to cable management system 1 of the present embodiment, the cable purchaser can view the specification information and the installation instruction (installation instruction sheet), which are the cable-related information of the cable, using mobile terminal 10. Furthermore, according to cable management system 1 of the present embodiment, it is possible to add a function as a customer portal, such as registering trouble information when a trouble has occurred.

Cable management system 1 according to the present embodiment is a cable management system using an application operating on a mobile terminal (mobile terminal 10) provided by a seller. According to cable management system 1 of the present embodiment, the seller can access the cable information that has input to server 20, and a customer can input the usage information each time the cable is used.

Server 20 may display the inventory information on a display connected to server 20 based on the cable usage information. Server 20 may display the inventory information via a computer connected to server 20 based on the cable usage information. Similarly, server 20 may display the cable information on a display connected to server 20. Server 20 may also be configured to allow a computer connected to server 20 to access the cable information.

The present invention can be implemented not only as a cable management system including such characteristic processing units, but also as a cable management method including such characteristic processing as steps, and as a program for causing a computer to execute such steps. The present invention can also be implemented as a semiconductor integrated circuit that configures a part of the cable management system.

Each of mobile terminal 10 and server 20 in cable management system 1 is provided with a computer including a CPU (microprocessor), a ROM, a RAM, and the like.

An arithmetic processing unit, such as a CPU (microprocessor), reads a computer program including a part or all of the steps of the sequence diagrams or the flowcharts as illustrated in FIG. 5, FIG. 6, and FIG. 7 from a storage unit, such as a ROM or a RAM, and executes the computer program. The computer programs for the plurality of devices can be installed from an external server device or the like. The computer programs for the plurality of devices are distributed as stored in a recording medium, such as a CD-ROM, a DVD-ROM, or a semiconductor memory.

In the above description, the cable drum is used as the storage member for storing a cable, but the storage member is not limited to the cable drum, and may be, for example, a bobbin or a box for a cable.

The embodiments disclosed herein are to be considered as illustrative and non-restrictive in all respects. The scope of the present invention is defined by the appended claims, not in the sense described above, and is intended to include all modifications within the scope and meaning equivalent to the appended claims.

### REFERENCE SIGNS LIST

1 cable management system
10 mobile terminal
11 CPU
12 RAM
13 ROM
14 storage I/F
14a recording medium
15 wireless I/F
16 audio input/output I/F
16a microphone
16b speaker
17 camera I/F
17a camera
18 positioning circuit
19 display
20 server
21 CPU
22 RAM
23 ROM
24 storage I/F
24a storage medium
25 communication I/F
112 identification information input unit
114 cable length input unit
116 storage location information input unit
122 screen display unit
130 communication unit
212 cable shipment information operation unit
214 cable usage information operation unit
216 cable-related information operation unit
220 storage unit
222 cable shipment information database
224 cable usage information database
226 cable-related information database
230 communication unit
B1, B2 bus
NW network
S10, S20, S30, S32, S34, S40, S42, S44, S50, S52, S54, S55, S60, S62, S70 step

## Claims

1. A cable management system for managing a cable,
the cable management system comprising a mobile terminal and a server, wherein
the server includes a storage unit configured to store cable information including information on the cable,
the mobile terminal includes:
means configured to transmit identification information of the cable to the server, the identification information of the cable being assigned to a storage member configured to store the cable; and
means configured to display the cable information transmitted from the server, and
the server includes:
means configured to extract the cable information from the storage unit, based on the identification information transmitted from the mobile terminal; and
means configured to transmit the extracted cable information to the mobile terminal.

2. The cable management system according to claim 1, wherein
the cable information includes a product name of the cable and a cable length at a time of shipment.

3. The cable management system according to claim 1 or 2, wherein
the storage member is provided with an identification mark including the identification information, and
the mobile terminal further includes:
means configured to capture an image of the identification mark; and
means configured to extract the identification information from the captured image of the identification mark.

4. The cable management system according to any one of claims 1 to 3, wherein
the server stores usage information in the storage unit, the usage information including information on usage of the cable,
the usage information includes a remaining cable length,
the mobile terminal further includes:
means configured to capture an image of a length mark near a top end of the cable;
means configured to extract length information from the captured image of the length mark; and
means configured to transmit the extracted length information to the server, and
the server further includes
means configured to update the remaining cable length in the usage information, based on the length information having been received.

5. The cable management system according to claim 4, wherein
the usage information includes position information,
the mobile terminal further includes:
means configured to perform position measurement in vicinity of the storage member; and
means configured to transmit a positioning result obtained by the position measurement to the server, and
the server further includes
means configured to update the position information in the usage information, based on the positioning result having been received.

6. The cable management system according to claim 4 or 5, wherein
the server displays an inventory of a purchaser having purchased the cable, based on the usage information.

7. The cable management system according to claim 1 or 2, wherein
the cable information further includes specification information, an installation instruction, shipment data, and inspection data.

8. The cable management system according to any one of claims 1 to 7, wherein
the cable information includes content of a trouble.

9. The cable management system according to any one of claims 1 to 8, wherein
the storage member is a cable drum.

10. The cable management system according to any one of claims 1 to 8, wherein
the storage member is a box.

11. A cable management method using a cable management system including a mobile terminal and a server, wherein
the server includes a storage unit configured to store cable information including information on a cable,
the mobile terminal executes:
transmitting identification information of the cable to the server, the identification information of the cable being assigned to a storage member configured to store the cable; and
displaying the cable information transmitted from the server, and
the server executes:
extracting the cable information from the storage unit, based on the identification information transmitted from the mobile terminal; and
transmitting the extracted cable information to the mobile terminal.
